# EUROPEAN PATENT APPLICATION

(11) **EP 4 678 079 A1**
(43) Date of publication of application: **14.01.2026**
(21) Application number: 24781349.6
(22) Date of filing: 14.03.2024
(51) Int. Cl.: A47L 9/28, A47L 9/22, A47L 9/32, A47L 5/24, H05K 1/18

(54) **CLEANER**

(30) Priority: 28.03.2023 KR 20230040497
(71) Applicant: LG Electronics Inc., Yeongdeungpo-gu Seoul 07336 (KR)
(72) Inventor: LIM, Junhyung, Seoul 08592 (KR); HYUN, Kietak, Seoul 08592 (KR); PARK, Heegu, Seoul 08592 (KR); HAN, Jaehun, Seoul 08592 (KR); HWANG, Inkyu, Seoul 08592 (KR)
(74) Representative: Ter Meer Steinmeister & Partner
(86) International application number: PCT/KR2024/095500
(87) International publication number: WO 2024/205360

(57) **Abstract**

Disclosed is a cleaner, including: a suction part in which a suction flow path through which air flows is formed; a dust separating part comprising at least one cyclone unit; a suction motor configured to provide a flow force of air; a main body housing having the suction part provided on one side thereof and the dust separating part and the suction motor provided therein; a battery configured to supply power to the suction motor; and a printed circuit board having at least one surface opposed to each of the suction motor and the battery, and a plurality of elements mounted therein, thereby there is an effect that wiring to be connected to the printed circuit board can be minimized.

## Description

### Technical Field

The present disclosure relates to a cleaner, more particularly, a cleaner capable of reducing a material cost by minimizing wiring of the printed circuit board.

### Background Art

A cleaner is a device that performs cleaning by suctioning or wiping dust or debris located in a cleaning target area.

The cleaner may include an impeller and a motor configured to rotate the impeller so as to provide a driving force for sucking in dust. The cleaner may generate the suctioning force by reducing an internal pressure by discharging internal air to the outside through an operation of the motor. The suctioning force generated as described above sucks in foreign substances such as dust on a cleaning surface together with external air through a suctioning means, and the foreign substances sucked in together with the external air may be removed by a dust collecting device and the like.

In addition, manual cleaners may fall into, depending on the types, a canister cleaner, an upright cleaner, a handy cleaner, and a stick cleaner.

Meanwhile, due to an increasing demand on the handheld cleaner, compactization and lightweight construction of an electric part module embedded in the cleaner has been continuously requested, and at the same time, increase of the rotating speed of the motor and the capacity of the inverter has been requested so as to improve the suction force.

In Korea Patent No. 10-2021-0027810A, a motor driving device and a cleaner including a printed circuit board in which a plurality of elements is mounted is disclosed.

The cleaner has the printed circuit board which is disposed on an inside of the main body housing so as to be connected to the suction motor.

However, there is a problem in that a size of the printed circuit board decreases so as to be disposed on the inside of the main body of the cleaner, and all the elements mounted therein must be installed on the small-sized printed circuit board, and therefore, a degree of integration increases and a degree of heat generation gets worse.

In addition, as the printed circuit board is disposed on the inside of the main body housing, and the battery is coupled to the outside of the main body housing, there is a problem in that a length of the needed wiring is elongated.

In particular, there is a problem in that the printed circuit board must be connected to the peripheral parts installed in the cleaner and in need of an electric signal, and wiring needed to connect it to the peripheral parts is elongated.

In addition, as the printed circuit board is connected to the peripheral parts through wiring, the wiring structure becomes complex and connector wiring is needed, and a resistance due to the connector wiring is generated, thereby the efficiency is degraded. In particular, as the wiring is elongated and becomes complex, the overall weight of the cleaner increases, the expenses increase, and the assembly process is complicated.

As a result, there is a limitation in that the cleaner described above experienced increasing expenses and weight because of the complex wiring, thereby the product competitiveness is degraded.

### DISCLOSURE

### Technical Problem

The present disclosure is derived so as to improve the problems of the conventional cleaner as described above, and an object of the present disclosure is to provide a cleaner capable of minimizing wiring to be connected to the printed circuit board. In particular, an object of the present disclosure is to provide a cleaner capable of minimizing wiring between the suction motor and the printed circuit board and wiring between the battery and the printed circuit board.

In addition, an object of the present disclosure is to provide a cleaner capable of reducing a resistance due to wiring of a connector, decreasing the overall weight of the cleaner, and saving expenses.

In addition, an object of the present disclosure is to provide a cleaner capable of sufficiently securing an area in which the plurality of elements is mounted as the printed circuit board is disposed elongated in upward and downward directions between the main body housing and the handle housing.

In addition, an object of the present disclosure is to provide a cleaner which is advantageous in easing generation of heat generated when the cleaner is operated and has a low degree of integration as the placement freedom of the plurality of elements mounted on the printed circuit board increases.

### Technical Solution

One embodiment is a cleaner, including: a suction part in which a suction flow path through which air flows is formed; a dust separating part comprising at least one cyclone unit; a suction motor configured to provide a flow force of air; a main body housing having the suction part provided on one side thereof and the dust separating part and the suction motor provided therein; a battery configured to supply power to the suction motor; and a printed circuit board having at least one surface opposed to each of the suction motor and the battery, and a plurality of elements mounted therein.

The cleaner may further include: a handle housing coupled to the main body housing to provide a handle and to which the battery is detachably coupled, and the printed circuit board may be disposed in upward and downward directions of the main body housing and an upper end thereof may be disposed to be opposed to the suction motor and a lower end thereof may be disposed to be opposed to the battery.

The handle housing may include: a main body coupling portion coupled to the main body housing; and a seating portion configured to allow the printed circuit board to be accommodated in the main body coupling portion to be fixed thereto.

The main body housing may include: at least one board supporting portion protruding toward the printed circuit board on an outer circumferential surface of the main body housing so that the printed circuit board is seated thereon to be fixed thereto.

In the main body housing, the suction motor may be disposed on an inside thereof and the printed circuit board may be disposed on an outside thereof.

In the printed circuit board, a battery connecting element configured to allow the battery to be attached or detached thereto/therefrom and electrically connected thereto may be mounted and a motor connecting element to which the suction motor is electrically connected may be mounted.

The printed circuit board may allow the battery connecting element to be mounted on one surface thereof, and the motor connecting element to be mounted on another surface thereof.

The printed circuit board may allow the battery connecting element and the motor connecting element to be mounted on one surface thereof.

In the printed circuit board, the suction motor may be in direct contact with the motor connecting element to be connected to each other.

In the printed circuit board, the suction motor may be connected to the motor connecting element through wiring.

The printed circuit board may be disposed along a direction intersecting a direction in which the suction part is disposed.

Another embodiment is a cleaner, including: a main body housing having a suction part in which a suction flow path through which air flows is formed, a dust separating unit configured to separate dust from air, and a suction motor configured to provide a suction force to the suction part; a handle housing coupled to the main body housing and to which a battery configured to supply power to the suction motor is detachably coupled; and a printed circuit board electrically connected to the suction motor and the battery, and the printed circuit board may be disposed between the main body housing and the handle housing and is fixed to the main body housing, or the handle housing.

Still another embodiment is a cleaner, including: a suction part in which a suction flow path through which air flows is formed; a dust separating unit configured to separate dust from the air sucked through the suction part; a suction motor configured to generate a suction force for sucking in air through the suction part; a battery configured to supply power to the suction motor; and a printed circuit board disposed in a direction intersecting a direction in which the suction part is disposed and having one end to which the battery is electrically connected and another end to which the suction motor is electrically connected.

### Advantageous Effect

According to the cleaner according to the present disclosure as described above, it is possible to minimize wiring to be connected to the printed circuit board, and in particular, there is an effect that wiring between the suction motor and the printed circuit board and wiring between the battery and the printed circuit board can be minimized.

In addition, there is an effect that a resistance due to connector wiring can be reduced, the overall weight of the cleaner can be reduced and expenses can be saved because wiring to be connected to the printed circuit board is minimized. Further, there is an effect in that the assembly process is simplified compared to the conventional cleaner, and the electrical connection and installation of the printed circuit board is made easier.

Moreover, there is an effect in that the area in which the plurality of elements is mounted can be sufficiently secured because the printed circuit board is disposed elongated in the upward and downward directions between the main body housing and the handle housing. As a result, it is advantageous that the placement freedom of the plurality of elements mounted on the printed circuit board increases, the degree of integration decrease, and heat generated when operating the cleaner is eased.

### Description of Drawings

FIG. 1 is a perspective view of a cleaner of an embodiment of the present disclosure.
FIG. 2 is a perspective view of a cleaner main body according to an embodiment of the present disclosure viewed in another direction.
FIG. 3 is a cross-sectional view for describing an internal structure of a cleaner according to an embodiment of the present disclosure.
FIG. 4 is a view for describing an arrangement structure of a suction motor, a printed circuit board, and a battery in a cleaner according to an embodiment of the present disclosure.
FIG. 5 is a perspective view illustrating a handle housing of a cleaner according to an embodiment of the present disclosure.
FIG. 6 is a perspective view illustrating a main body housing of a cleaner according to an embodiment of the present disclosure.
FIG. 7 is a perspective view illustrating a printed circuit board of a cleaner according to an embodiment of the present disclosure.
FIG. 8 is a perspective view illustrating a main body housing of a cleaner according to another embodiment of the present disclosure.
FIG. 9 is a view for describing an arrangement structure of a suction motor, a printed circuit board, and a battery according to another embodiment of the present disclosure.
FIG. 10 is a view for describing an arrangement structure of a suction motor, a printed circuit board, and a battery according to still another embodiment of the present disclosure.
FIG. 11 is a block diagram for describing control of a cleaner according to an embodiment of the present disclosure.

### Mode for Invention

Hereinafter, exemplary embodiments of the present disclosure will be described in detail with reference to the accompanying drawings.

The present disclosure may be variously modified and may have various embodiments, and particular embodiments illustrated in the drawings will be specifically described below. The description of the embodiments is not intended to limit the present disclosure to the particular embodiments, but it should be interpreted that the present disclosure is to cover all modifications, equivalents and alternatives falling within the spirit and technical scope of the present disclosure.

The terminology used herein is used for the purpose of describing particular embodiments only and is not intended to limit the present disclosure. Singular expressions may include plural expressions unless clearly described as different meanings in the context.

Unless otherwise defined, all terms used herein, including technical or scientific terms, may have the same meaning as commonly understood by those skilled in the art to which the present disclosure pertains. The terms such as those defined in a commonly used dictionary may be interpreted as having meanings consistent with meanings in the context of related technologies and may not be interpreted as ideal or excessively formal meanings unless explicitly defined in the present application.

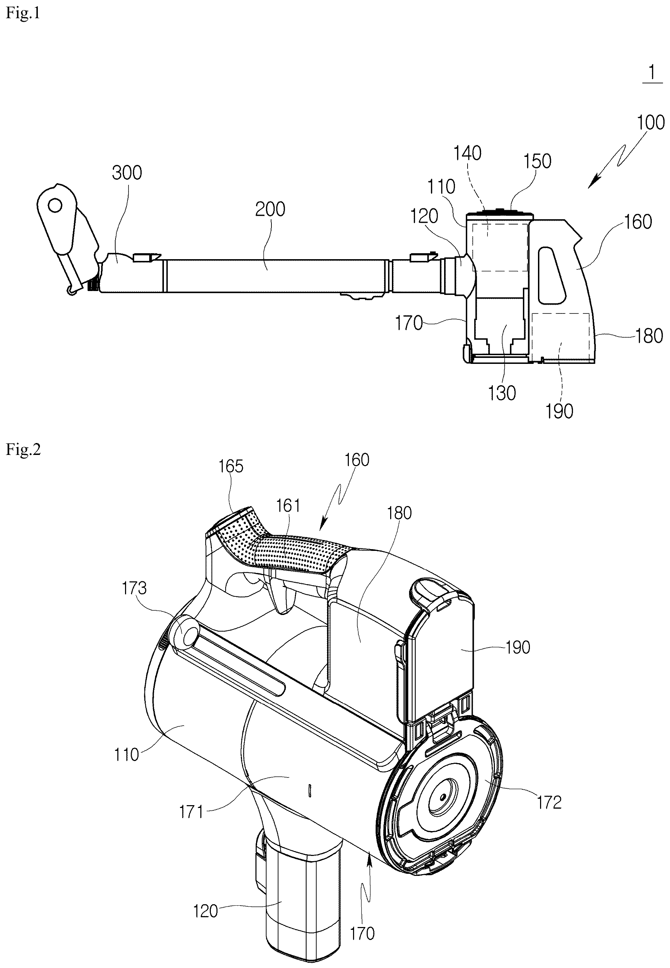

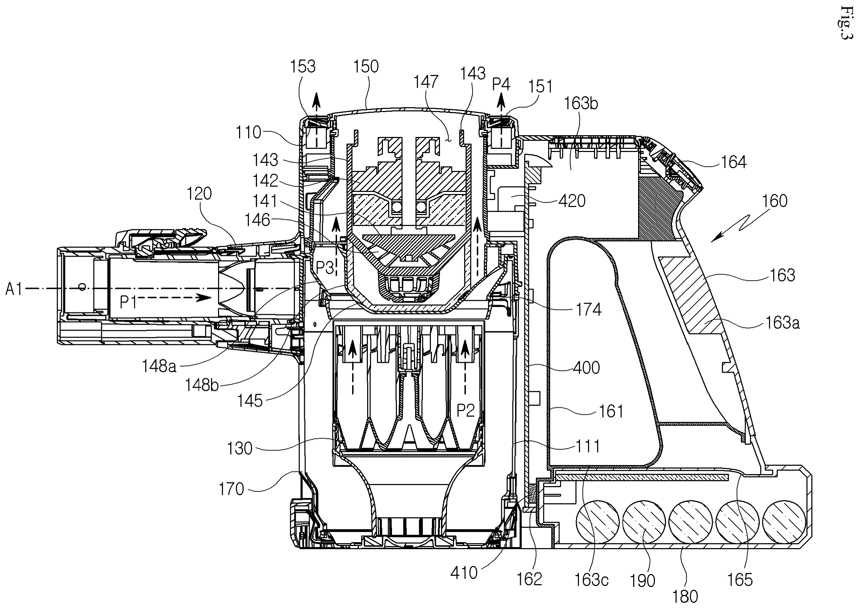

FIG. 1 is a perspective view of a cleaner according to an embodiment of the present disclosure, FIG. 2 is a perspective view of a cleaner main body according to an embodiment of the present disclosure viewed in another direction, and FIG. 3 is a cross-sectional view for describing an internal structure of a cleaner according to an embodiment of the present disclosure.

Referring to FIGS. 1 to 3, the cleaner 1 according to an embodiment of the present disclosure may include a cleaner main body 100 having a suction motor 142 configured to generate a suction force, a suction module 300 connected to the cleaner main body 100 and configured to suck in air and debris on a floor surface, and an extension tube 200 connecting the cleaner main body 100 and the suction module 300 to each other.

A structure of the cleaner main body 100 will be described as below.

In the present disclosure, it is understood that "a floor surface" means not only a floor surface of a living room or a room, but also, a surface to clean up such as a carpet and the like.

Meanwhile, in the embodiment of the present disclosure, directions may be defined on the basis of a state in which a bottom surface (lower surface) of a dustbin 170 and a bottom surface (lower surface) of a battery housing 230 are placed on a ground surface.

In this case, a forward direction may mean a direction in which a suction part 120 is disposed based on the suction motor 142, and a rear direction may mean a direction in which a handle 163 is disposed based on the suction motor 142. Further, on the basis of a state in which the suction part 120 is viewed from the suction motor 142, a right direction may refer to a direction in which a component is disposed at the right, and a left direction may refer to a direction in which a component is disposed at the left. In addition, in the embodiment of the present disclosure, upper and lower sides may be defined in a direction perpendicular to the ground surface on the basis of the state in which the bottom surface (lower surface) of the dustbin 170 and the bottom surface (lower surface) of a battery housing 180 are placed on the ground surface.

The cleaner 1 may include the cleaner main body 100. The cleaner main body 100 may include a flow path, which is configured to guide the sucked air to be discharged to the outside, formed on an inside thereof.

In more detail, the cleaner main body 100 may include a main body housing 110, the suction part 120, a dust separating part 130, a fan driver 140, an air discharge cover 150, a handle housing 160, the dustbin 170, the battery housing 180, and a battery 190.

The main body housing 110 may define an external appearance of the cleaner 100. The main body housing 110 may provide a space that may accommodate therein the fan driver 140 and a pre-filter 145. For example, the main body housing 110 may be formed in a shape similar to a cylinder.

The suction part 120 may protrude outward from the main body housing 110. For example, the suction part 120 may be formed in a cylindrical shape with an opened inside. The suction part 120 may be coupled to the extension tube 200. The suction part 120 may provide a flow path P1 through which air containing dust may flow.

The dust separating part 130 is communicated with the suction part 120, and the dust separating part 130 is configured to apply a principle of a dust collector using a centrifugal force so as to separate dust sucked into the cleaner main body 100 through the suction part 120. An internal space of the dust separating part 130 may be communicated with an internal space of the dustbin 170.

For example, the dust separating part 130 may include at least one or more cyclone units configured to separate dust through a cyclonic flow. In addition, the internal space of the dust separating part 130 may be communicated with a flow path P2 formed in the suction part 120. Therefore, air and dust sucked in through the suction part 120 may spirally flow along an inner circumferential surface of the dust separating part 130. Thus, a cyclonic flow may occur in the internal space of the dust separating part 130.

The fan driver 140 may generate a flow force disposed in the flow path and moving air in the flow path.

The fan driver 140 may include an impeller 141, and the suction motor 142 configured to rotate the impeller 141.

The impeller 141 may be disposed on the suction motor 142. A shaft of the suction motor 142 is inserted into a center of the impeller 141 so that the center of the impeller 141 and the shaft of the suction motor 142 are disposed to be coaxial. At this instance, the shaft of the suction motor 142 may be fixed to the center of the impeller 141. With this configuration, when the suction motor 142 is driven, the impeller 141 rotates together with the shaft of the suction motor 142 so that a flow force of air can be generated. At this instance, the shaft of the suction motor 142 may be disposed in upward and downward directions of the main body housing 110, but is not limited thereto.

The suction motor 142 may include a stator in a ring shape, a shaft penetrating a center of the stator, and a rotor configured to generate a rotational force by the stator, for example. Meanwhile, the suction motor 142 in the present embodiment uses a brushless direct current motor (BLDC motor), but is not limited thereto, and various types of motor may be applied.

Such a suction motor 142 may operate by receiving power of the battery 190 which will be described below, and may include a suction motor control board 142a. The suction motor control board 142a may input a control signal to the suction motor 142 so as to operate the suction motor 142, or may supply power of the battery 190 to the suction motor 142. Such a suction motor control board 142a may include a plurality of switching elements, and by controlling the plurality of switching elements, may input a control signal to the suction motor 142, or supply power of the battery 190 to the suction motor 142. Here, the suction motor control board 142a may be an inverter.

In addition, the suction motor control board 142a may be connected to a printed circuit board 400 which will be described below, and may be directly connected to the printed circuit board 400 or may be connected via a line 142b. In other words, the suction motor 142 may be connected to the printed circuit board 400 via connectors 142a and 142b, and the connectors 142a and 142b may be configured as the suction motor control board 142a, or the suction motor control board 142a and the line 142b.

The motor housing 142 may accommodate the suction motor 142, and may support a bearing (not illustrated) installed below or on the suction motor 142.

A side wall of the motor housing 143 may be formed in a cylindrical shape, and the stator of the suction motor 142 may be fixed on an inner surface of the side wall. In addition, in a state in which the suction motor 142 is accommodated and installed in the motor housing 143, a structure for supporting the bearing may be provided below or on the motor housing 143. In addition, although not illustrated, a part configured to generate a flow of air and a diffuser configured to distribute the generated flow of air may be further provided below or on the motor housing 143.

Meanwhile, an air discharge hole 147 may be formed on an upper surface, or a lower surface of the motor housing 143. For example, the air discharge hole 147 may be formed in a shape of a hole having a predetermined width along a circumferential direction on an upper surface of a lower surface of the motor housing 143. That is, the air discharge hole 147 may be a hole formed in a region between a predetermined inner radius and a predetermined outer radius, centering on a predetermined midpoint of the upper surface, or the lower surface of the motor housing 143. Meanwhile, the air discharge hole 147 may have a form of which the air discharge hole 147 is formed in plural number at a predetermined angle interval. That is, the air discharge hole 147 may be a hole in an arc shape formed in a predetermined angle range, centering on the midpoint, and the plurality of air discharge holes 147 may be formed in a shape close to a circular shape which is centered on the midpoint, in general.

An impeller cover 144 may be configured in a form of covering an upper side of the motor housing 143, for example. At a lower center, or an upper center of the impeller cover 144, an air inlet 146, which is a passage through which air is suctioned into the fan driver 140, may be formed.

The fan driver 140 may suck in air through the air inlet 146 provided at the lower center, or the upper center of the impeller cover 144, and may discharge air through the air discharge hole 147 provided along a circumferential direction on an upper surface, or a lower surface of the motor housing 143. With this configuration, heat of heating devices mounted in the printed circuit board 400 which will be described below may be effectively dissipated through air flowing in the fan driver 140.

The cleaner 1 may include the pre-filter 145 configured to filter air before air is sucked into the suction motor 142. The pre-filter 145 may be disposed to surround the impeller 141, for example. Air in a suction flow path P3 may reach the impeller 141 by passing through the pre-filter 145. The pre-filter 145 may be disposed on an inside of the cleaner main body 100. In more detail, the pre-filter 145 may be disposed at a position lower or upper than the suction motor 142. That is, the pre-filter 145 may be disposed between the dust separating part 130 and the suction motor 142.

The cleaner main body 100 may include an air guide 148 configured to guide air discharged from the dust separating part 130. The air guide 148 may be disposed between the main body housing 110 and the motor housing 143. The air guide 148 may form the suction flow path P3 guiding air from the dust separating part 130 to the impeller 141. The air guide 148 may form an exhaust flow path P4 guiding air, which has passed through the impeller 141, to an exhaust opening 151.

In more detail, the air guide 148 may include an outer guide 148a and an inner guide 148b. The outer guide 148a may be coupled to an inner circumferential surface of the main body housing 110, and may be a wall forming the suction flow path P3 through which air, which has passed through the dust separating part 130, is introduced into the air inlet 146 by forming a space with the inner guide 148b. The inner guide 148b may be a wall accommodating the motor housing 143 therein, and forming the exhaust flow path P4 guiding air, which has been discharged from the air discharge hole 147, to the exhaust opening 151.

At this instance, the suction flow path P3 and the exhaust flow path P4 may be formed at a predetermined interval along a circumference of the motor housing 143, centering on the motor housing 143, as illustrated in FIG. 3. For example, along the circumference of the motor housing 143, three suction flow paths P3 and three exhaust flow paths P4 may be formed along the circumference of the motor housing 143.

With this configuration, the air guide 148 may form the flow paths P3 and P4 so that air discharged from the dust separating part 130 can pass through the impeller 141 to go up, and can go up to the exhaust opening 151 again.

Therefore, air and dust sucked through the flow path P1 inside the suction part 120 by the operation of the suction motor 142 may be separated from each other while flowing in the flow path P2 inside the dust separating part 130, for example. Air in which dust is separated in the dust separating part 130 may move upward, and may be introduced into the suction flow path P3 inside the fan driver. The suction flow path P3 may guide air toward the pre-filter 145. Air, which has passed through the pre-filter 145 and the impeller 141 sequentially, may be introduced into the exhaust flow path P4, pass through a HEPA filter 143, and be discharged to the outside through the exhaust opening 151.

Meanwhile, the cleaner 1 according to an embodiment of the present disclosure may include the printed circuit board PCB 400 for controlling the suction motor 142, an operating part 164, the battery 190 and the like. The printed circuit board 400 may have a plurality of elements mounted therein, and the suction motor 142 and the battery 190 may be electrically connected thereto. For example, the printed circuit board 400 may extend from a position at which the battery 190 is disposed to a position at which the suction motor 142 is disposed, and both ends thereof may be disposed adjacent to the battery 190 and the suction motor 142, respectively. The printed circuit board 400 will be described in more detail below.

The air discharge cover 150 may form an external appearance of an upper side of the cleaner main body 100, and may cover an upper portion of the motor housing 143 and the impeller cover 144.

The air discharge cover 150 may be disposed on one side of the main body housing 110 in an axial direction.

The exhaust opening 151 through which air in the flow path is discharged to the outside of the cleaner main body 100 may be formed in the air discharge cover 150.

The exhaust opening 151 may be disposed to face a certain direction, for example. For example, the plurality of exhaust openings 151 may be divided from each other in a circumferential direction by a plurality of exhaust guides 152. The plurality of exhaust openings 151 may be spaced apart from each other at a certain interval along a circumferential direction.

In the air discharge cover 150, a filter configured to filter air before air is discharged to the exhaust opening 151 may be accommodated. For example, the HEPA filter 153 may be accommodated in the air discharge cover 150.

Air, which has passed through the fan driver 140, may be discharged to the outside through the exhaust opening 151. The HEPA filter 153 may be disposed in the exhaust flow path P4.

In the air discharge cover 150, a filter accommodating space for accommodating the HEPA filter 153 may be formed. The filter accommodating space may be formed such that a lower side thereof is opened and thus, the HEPA filter 153 may be accommodated on a lower side of the air discharge cover 150.

The exhaust opening 151 and the HEPA filter 153 may be formed to face each other. For example, the HEPA filter 153 may be disposed on a lower side of the exhaust opening 151. The HEPA filter 153 may extend, for example, in a circumferential direction along the exhaust opening 151.

The dustbin 170 may be disposed on a lower side of the main body housing 110. The dustbin 170 may be communicated with the dust separating part 130. The dustbin 170 may store dust separated in the dust separating part 130.

The dustbin 170 may include a dustbin main body 171.

The dustbin main body 171 may provide a space capable of storing the dust separated by the dust separating part 130. For example, the dustbin main body 171 may be formed in a shape similar to a cylindrical shape.

For example, the dustbin main body 171 may be provided such that a lower surface thereof can be opened. At this instance, a discharge cover 172 is provided on a lower surface of the dustbin main body 171 and may selectively open the lower surface of the dustbin main body 171.

The discharge cover 172 may be provided to open or close the lower surface of the dustbin main body 171. The discharge cover 172 may be rotatably coupled to a lower side of the dustbin main body 171. The discharge cover 172 may be hingedly coupled to the dustbin main body 171 and may open or close the lower side of the dustbin 170 through a rotating motion.

Meanwhile, according to an embodiment, the dustbin 170 may further include a dustbin compression lever 173 and a compression member 174.

The dustbin compression lever 173 may be disposed outside the dustbin 170 or the dust separating part 130. The dustbin compression lever 173 may be disposed outside the dustbin 170 or the dust separating part 130 to be movable in upward and downward directions. The dustbin compression lever 173 may be connected to the compression member 174. When the dustbin compression lever 173 is moved downward by an external force, the compression member 174 may be moved downward together. Through this configuration, it is possible to provide convenience to the user. The compression member 174 and the dustbin compression lever 173 may return to its original position by an elastic member (not illustrated). In more detail, when the external force applied to the dustbin compression lever 173 is removed, the elastic member may move the dustbin compression lever 173 and the compression member 174 upward.

The compression member 174 may be disposed inside the dustbin main body 171. The compression member 174 may move in the internal space of the dustbin main body 171. In more detail, the compression member 174 may move upward and downward in the dustbin main body 171. With this configuration, the compression member 174 may compress the dust in the dustbin main body 171 downward. In addition, when the discharge cover 172 is separated from the dustbin main body 171 and thus the lower side of the dustbin 170 is opened, the compression member 174 may move from an upper side of the dustbin 170 to the lower side of the of the dustbin 170, thereby removing foreign substances such as residual dust in the dustbin 170. With this configuration, it is possible to improve the suction force of the cleaner by preventing the residual dust from remaining in the dustbin 170. Further, it is possible to remove an offensive odor caused by the residual dust by preventing the residual dust from remaining in the dustbin 170.

The battery 190 may be accommodated in the battery housing 180. The battery housing 180 may be detachably coupled to the handle housing 160, and may be disposed below the handle 163. In addition, the battery housing 180 may be detachably coupled to a battery fastening portion 165 formed in a second extension 163c, and may be provided such that the battery 190 is electrically connected to the printed circuit board 400.

For example, the battery housing 180 may have a hexahedral shape opened at a lower side thereof. A rear surface of the battery housing 180 may be connected to the handle 163. In this case, the battery housing 180 may include an accommodating portion which is opened downward. With this configuration, the battery 190 may be detached through the accommodating portion of the battery housing 180.

As another example, the battery housing 180 may be provided integrally in a state in which the battery 190 is accommodated on an inside thereof.

The battery 190 is configured to supply power to the cleaner 1. In more detail, the battery 190 may supply power to the suction motor 142, and may supply power to an electronic circuit, an electronic part, and the like inside the cleaner 1. In addition, the battery 190 may supply power to the suction module 300.

When the battery 190 is coupled to the battery housing 180, a lower surface of the battery 190 may be exposed outside. When placing the cleaner 1 on the ground, the battery 190 may be placed on the ground, and therefore, the battery 190 may be directly separated from the battery housing 180. In addition, because the lower surface of the battery 190 is exposed to the outside and directly contacts external air outside the battery 190, a cooling performance of the battery 190 may be improved.

Meanwhile, when the battery 190 is integrally fixed to the battery housing 180, a structure for detachment between the battery housing 180 and the battery 190 may be removed, and thus, the overall size and the weight of the cleaner 1 may be reduced.

In addition, the battery 190 may be detachably coupled to the handle housing 160, and may be provided in a shape of a rectangular parallelepiped elongated along one direction and having a long side. For example, as illustrated in the drawing, the long side of the battery 190 may be disposed along forward and rearward directions.

Meanwhile, the cleaner 1 may include the extension tube 200.

The extension tube 200 may be coupled to the cleaner main body 100 and the suction module 300. One end of the extension tube 200 may be detachably coupled to the suction part 120. In addition, another end of the extension tube 200 may be detachably coupled to the suction module 300.

For example, the extension tube 200 may be formed in a shape of a long cylinder. Therefore, an internal space of the extension tube 200 may be communicated with an internal space of the cleaning module 300. In addition, the extension tube 200 may be communicated with the suction flow path formed in the suction part 120 of the cleaner main body 100.

When the suction force is generated through the suction motor 142, the suction force may be provided to suction module 300 through the suction part 120 and the extension tube 200. In addition, dust and air introduced through the suction module 300 may pass through the extension tube 200, and then may be introduced into the cleaner main body 100. In addition, dust and air introduced into the cleaner main body 100 and passed through the suction part 120 may be separated in the dust separation part 130, and dust may be stored in the dustbin 170, and air may be discharged to the outside through the air discharge cover 150.

The suction module 300 may move along a ground surface, and may suck in dust on the ground surface. In addition, the suction module 300 may be connected to the cleaner main body 100 through the extension tube 200.

Meanwhile, although not illustrated, the suction module 300 may be directly connected to the cleaner main body 100 without the extension tube 200.

In general, in the cleaner main body 100, when the suction motor 142 is disposed on an upper side, the battery 190 may be disposed on a lower side. Alternatively, in the cleaner main body 100, when the suction motor 142 is disposed on a forward side, the battery 190 may be disposed on a rear side, and when the battery 190 is disposed on one side in left and right directions, the suction motor 142 may be disposed on another side in the left and right directions. That is, in the cleaner main body 100, the suction motor 142 and the battery 190 may be spaced apart from each other at a certain interval.

Because of this, wiring for connection to the suction motor 142 and the battery 190 of the printed circuit board 400 may be elongated and become complex regardless that the printed circuit board 400 is disposed anywhere of the cleaner main body 100.

Therefore, the cleaner 1 according to the present disclosure aims to prevent the wiring between the suction motor 142, the printed circuit board 400, and the battery 190 from being elongated and complex.

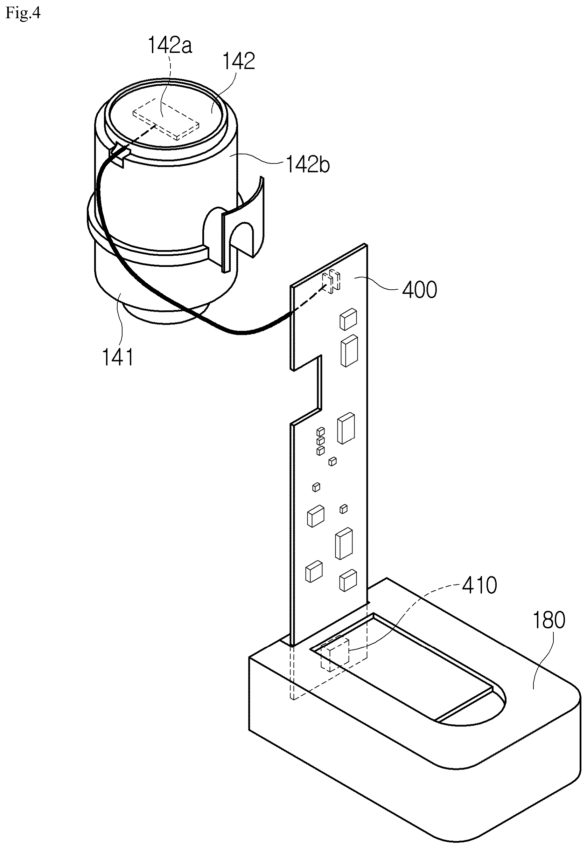

FIG. 4 is a view for describing an arrangement structure of the suction motor, the printed circuit board, and the battery in the cleaner according to an embodiment of the present disclosure.

Referring to FIG. 4, the printed circuit board 400 according to an embodiment of the present disclosure will be described as below.

Each of the suction motor 142 and the battery 190 is electrically connected to the printed circuit board 400. As a result, the suction motor 142 may operate by receiving power of the battery 190. Here, the printed circuit board 400 may have wiring to be electrically connected to each of the suction motor 142 and the battery 190, and the printed circuit board 400 may be disposed to be adjacent to the suction motor 142 and the battery 190 so as to minimize the wiring. Alternatively, the printed circuit board 400 may be in direct contact with and electrically connected to the suction motor 142 and the battery 190.

In addition, the printed circuit board 400 may extend from a position where the suction motor 142 is disposed to a position where the battery 190 is disposed to a position where the suction motor 142 is disposed and accordingly, the printed circuit board 400 may be elongated along a direction intersecting a longitudinal axis A1 of the suction part 120.

That is, it is preferable that the suction motor 142 and the battery 190 are disposed on both sides of the suction part 120 to which the extension tube 200 is connected so that the weight is not biased to any one side. In addition, because both ends of the printed circuit board 400 are disposed adjacent to the suction motor 142 and the battery 190, the printed circuit board 400 is disposed to be elongated along a direction intersecting a direction in which the suction part 120 is disposed.

In addition, the printed circuit board 400 may be elongated along a direction intersecting the long side of the battery 190. Alternatively, the printed circuit board 400 may be elongated along a direction parallel to the short side of the battery 190, and may be disposed adjacent to the battery 190.

In addition, at least one surface of the printed circuit board 400 may be opposed to each of the suction motor 142 and the battery 190. For example, both the suction motor 142 and the battery 190 may be opposed to one surface of the printed circuit board 400. As another embodiment, the battery 190 may be opposed to one surface of the printed circuit board 400, and the suction motor 142 may be opposed to another surface thereof.

Alternatively, the printed circuit board 400 may be elongated in one direction, and one end thereof in the one direction may be opposed to the battery 190 and another end thereof in the one direction may be opposed to the suction motor 142.

Such a printed circuit board 400 may be in direct contact with the battery 190 to be electrically connected thereto. For example, the printed circuit board 400 may have a battery connecting element 410 mounted therein. The battery connecting element 410 may allow the battery 190 to be attached and detached thereto/therefrom and to be electrically connected to the printed circuit board 400. Such a battery connecting element 410 may be mounted on at least one surface of the printed circuit board 400.

The battery connecting element 410 is provided to maintain a state in which the battery 190 is electrically connected to the battery connecting element 410 when the battery 190 is coupled to the cleaner main body 100. For example, the battery connecting element 410 may have any one among a female connector and a male connector which allows electric connection when in contact therewith, and the battery 190 may have the remaining other among the female connector and the male connector. Accordingly, when the battery 190 is coupled to the cleaner main body 100, the battery connecting element 410 may be electrically connected to the battery 190.

However, the battery connecting element 410 may be connected to the battery 190 via wiring, and the printed circuit board 400 may be disposed adjacent to the battery 190 so as to reduce a length of the wiring which is connected.

In addition, the printed circuit board 400 may be in contact with the suction motor 142 to be electrically connected thereto, or may be connected to the suction motor 142 via wiring. For example, a motor connecting element 420 to which the suction motor 142 is electrically connected may be mounted in the printed circuit board 400.

The motor connecting element 420 may be electrically connected to the suction motor 142 as the suction motor control board 142a of the suction motor 142 is coupled thereto. For example, the motor connecting element 420 may have any one among a female connector and a male connector which allows electric connection when in contact therewith, and the suction motor control board 142a may have the remaining other among the female connector and the male connector. Alternatively, the motor connecting element 420 may be connected to the suction motor control board 142a via wiring, and wiring connected to the suction motor control board 142a may be connected thereto.

Here, in the cleaner 1 according to an embodiment illustrated in FIG. 4, the battery connecting element 410 may be mounted on one surface of the printed circuit board 400, and the motor connecting element 420 may be mounted on another surface of the printed circuit board 420. In addition, an axial direction of the suction motor 142 and an arrangement direction of the printed circuit board 400 may be disposed parallel to each other, and the suction motor control board 142a of the suction motor 142 may be connected to the motor connecting element 420 via the line 142b.

That is, the suction motor 142 may be disposed such that a motor axis thereof is disposed along upward and downward direction (an axial direction of the main body housing) and the printed circuit board 400 may be disposed to be elongated in the upward and downward directions.

In addition, the printed circuit board 400 may be disposed to be elongated along a direction perpendicular to the longitudinal axis A1 of the suction part 120, and the motor axis of the suction motor 142 may be disposed to be perpendicular to the longitudinal axis A1 of the suction part 120 at a position adjacent to another end thereof. In addition, at a position adjacent to one end of the printed circuit board 400, the battery 190 is disposed to be elongated along a direction parallel to the longitudinal axis A1 of the suction part 120, and as a terminal of the battery 190 contacts the battery connecting element 410 of the printed circuit board 400, the battery 190 may be electrically connected to the printed circuit board 400.

In addition, the motor axis of the suction motor 142 may be disposed to be perpendicular to the longitudinal axis A1 of the suction part 120, and the printed circuit board 400 may be disposed to be elongated in a direction perpendicular to the longitudinal axis A1 of the suction part 120.

For example, the printed circuit board 400 may be disposed in the upward and downward directions in the cleaner main body 100. In addition, an upper end of the printed circuit board 400 may be opposed to the suction motor 142, and a lower end of the printed circuit board 400 may be opposed to the battery 190. Accordingly, the upper end of the printed circuit board 400 may be connected to the suction motor 142, and the lower end thereof may be connected to the battery 190.

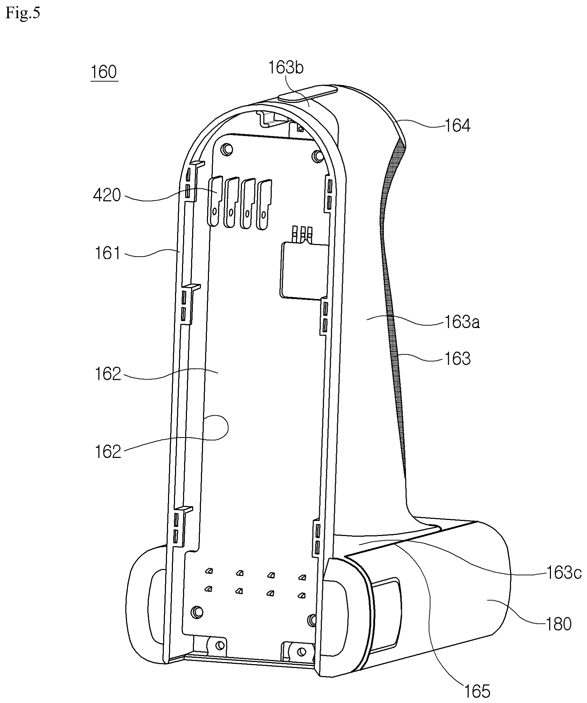

Such a printed circuit board 400 may be disposed in the upward and downward directions between the main body housing 110 and the handle housing 160, as illustrated in FIGS. 5 to 8.

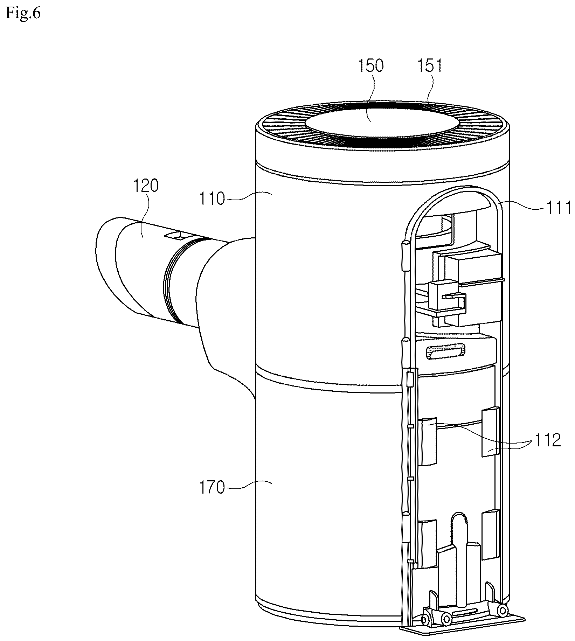

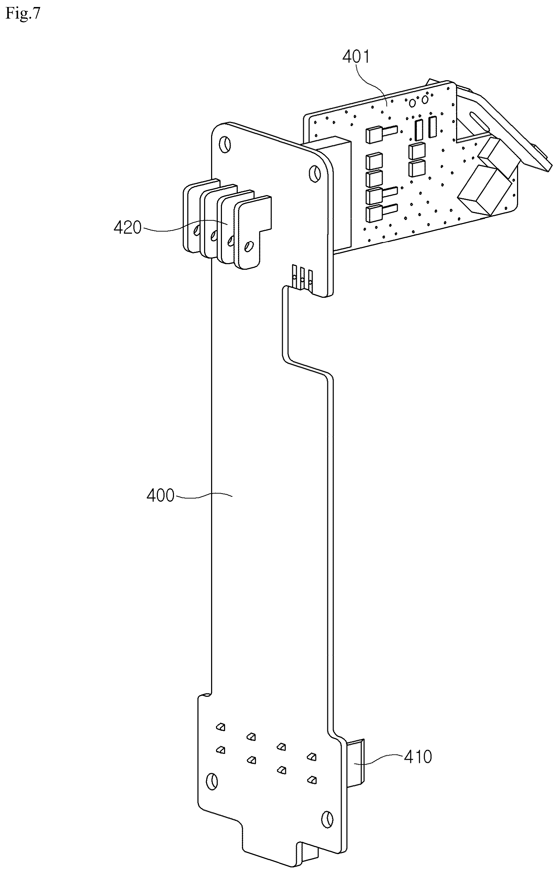

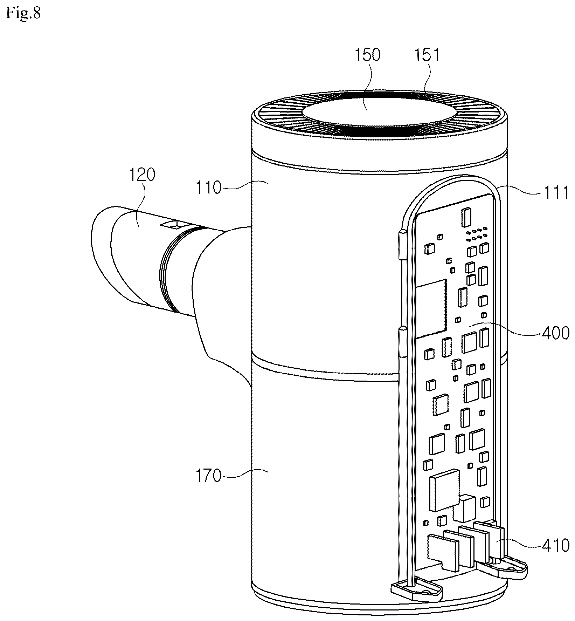

FIG. 5 is a perspective view illustrating the handle housing of the cleaner according to an embodiment of the present disclosure, FIG. 6 is a perspective view illustrating the main body housing of the cleaner according to an embodiment of the present disclosure, FIG. 7 is a perspective view illustrating the printed circuit board of the cleaner according to an embodiment of the present disclosure, and FIG. 8 is a perspective view illustrating the main body housing of the cleaner according to another embodiment of the present disclosure.

Referring to FIGS. 5 to 8, the printed circuit board 400 may be disposed in the upward and downward directions in the cleaner main body 100, and may be disposed on an outside of the main body housing 110. That is, in the main body housing 110, the suction motor 142 is disposed on the inside thereof, and the printed circuit board 400 may be disposed on an outside thereof. The printed circuit board 400 may be disposed in the upward and downward directions between the main body housing 110 and the handle housing 160.

The main body housing 110 may have a handle housing coupling portion 111 at a rear thereof. The handle housing coupling portion 111 may be inserted into an inside of a main body coupling portion 161 of the handle housing 160 to be coupled to the handle housing 160. Such a handle housing coupling portion 111 in a rib form may protrude outward from the main body housing 110, and may be inserted into the main body coupling portion 161.

The main body housing 110 may have at least one board supporting portion 112 protruding rearward from an outer surface thereof and configured to support a front surface of the printed circuit board 400. The board supporting portion 112 may have a protruding end surface which is formed as a flat surface in contact with the printed circuit board 400 so as to support the printed circuit board 400.

The handle housing 160 may be coupled to the main body housing 110 so as to provide the handle 163. In more detail, the handle housing 160 may include the main body coupling portion 161, the handle 163, a first extension 163b and the second extension 163c.

The main body coupling portion 161 is configured to be coupled to an outside of the main body housing 110, and may be coupled to the main body housing 110 as the handle housing coupling portion 111 of the main body housing 110 is inserted into an inside of the main body coupling portion 161 to be coupled thereto.

In addition, the main body coupling portion 161 may have a seating portion 162 on which the printed circuit board 400 is seated and fixed. The seating portion 162 may be formed such that part of a front side of the main body coupling portion 161 is recessed so as to provide a space in correspondence with the printed circuit board 400. The printed circuit board 400 may be fixed via a coupling member (not illustrated) in a state it is seated on the seating portion 162.

The handle 163 may be gripped by the user. The handle 163 may be disposed at a rear side of the suction motor 142. For example, the handle 163 may be formed in a shape similar to a cylindrical shape. Alternatively, the handle 163 may be formed in a curved cylindrical shape. The handle 163 may be disposed at a certain angle with respect to the main body housing 110, the suction motor 142, or the dust separating part 130.

The handle 163 may include a grip portion 163a formed in a column shape so that the user may grasp the grip portion 163a.

The operating part 164 may be disposed on the handle 163. The operating part 164 may be disposed on an inclined surface formed in an upper region of the grip portion 163a. The user may input an instruction to operate or stop the cleaner 1 through the operating part 164.

In addition, the handle 163 may include the first extension 163b connected to one end in the longitudinal direction (axial direction) of the grip portion 163a and extending toward the suction motor 142, and the second extension 163c connected to another end in the longitudinal direction (axial direction) of the grip portion 163a and extending toward the dustbin 170. The first extension 163b and the second extension 163c may be integrally connected to the upper end and the lower end of the main body coupling portion 161.

Accordingly, the handle 163 may form a space into which the user can put a handle or a finger between the first extension 163b and the second extension 163c, and allow the user to easily grasp the grip portion 163a.

An upper surface of the handle housing 160 may define an external appearance of a part of an upper surface of the cleaner 1. Therefore, it is possible to prevent a component of the cleaner 1 from coming into contact with the user's arm when the user grasps the handle 163.

An auxiliary printed circuit board 401 may be disposed in the first extension 163b. The auxiliary printed circuit board 401 may be electrically connected to the printed circuit board 400, and may deliver an input of the operating part 164 to the printed circuit board 400, or supply power to the operating part 164.

In addition, the second extension 163c includes the battery fastening portion 165 so that the battery can be detachably coupled thereto. For example, the battery 190 may be disposed in the forward and rearward directions along the second extension 163c. In addition, the battery 190 may be coupled to the second extension 163c to be electrically connected to the battery connecting element 410 of the printed circuit board 400.

For example, the printed circuit board 400 may be formed in a form of a long plate in the upward and downward directions as illustrated in FIG. 8, and the motor connecting element may be mounted in the upper end and the battery connecting element may be mounted in the lower end thereof.

In addition, the printed circuit board 400 may be fixed to the handle housing 160 as illustrated in FIGS. 5 to 8, or to the main body housing 110, as illustrated in FIG. 8.

First, referring to FIG. 5 or 6, the printed circuit board 400 may be seated on the seating portion 162 of the handle housing 160, and then, fixed to the handle housing 160. Such a printed circuit board 400 may be fixed to the handle housing 160 via at least one coupling member (not illustrated). In addition, when the handle housing 160 is coupled to the main body housing 110, the printed circuit board 400 may be supported on the board supporting portion 112 of the main body housing 110.

In addition, referring to FIG. 8, the printed circuit board 400 may be seated on the board supporting portion 112 of the main body housing 110 and then, fixed to the main body housing 110. Such a printed circuit board 400 may be fixed to the main body housing 110 via at least one coupling member (not illustrated). In addition, when the handle housing 160 is coupled to the main body housing 110, the printed circuit board 400 may be supported on the seating portion 162 of the handle housing 160.

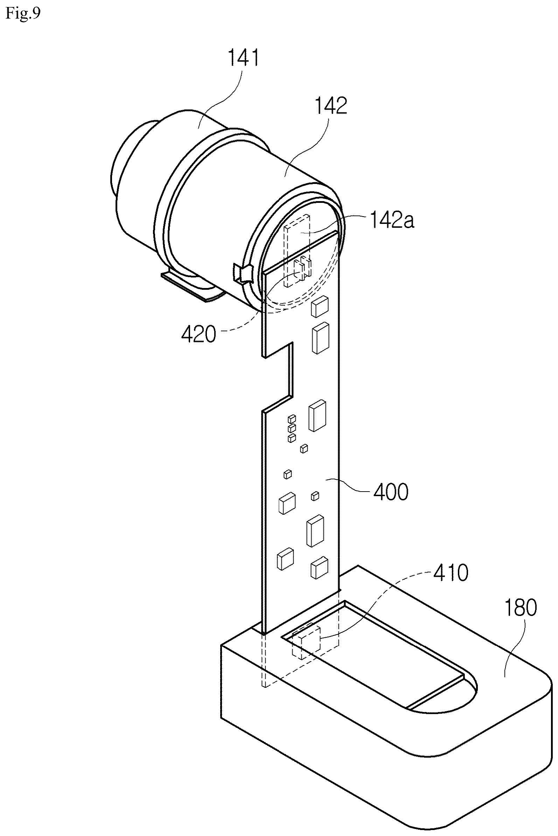

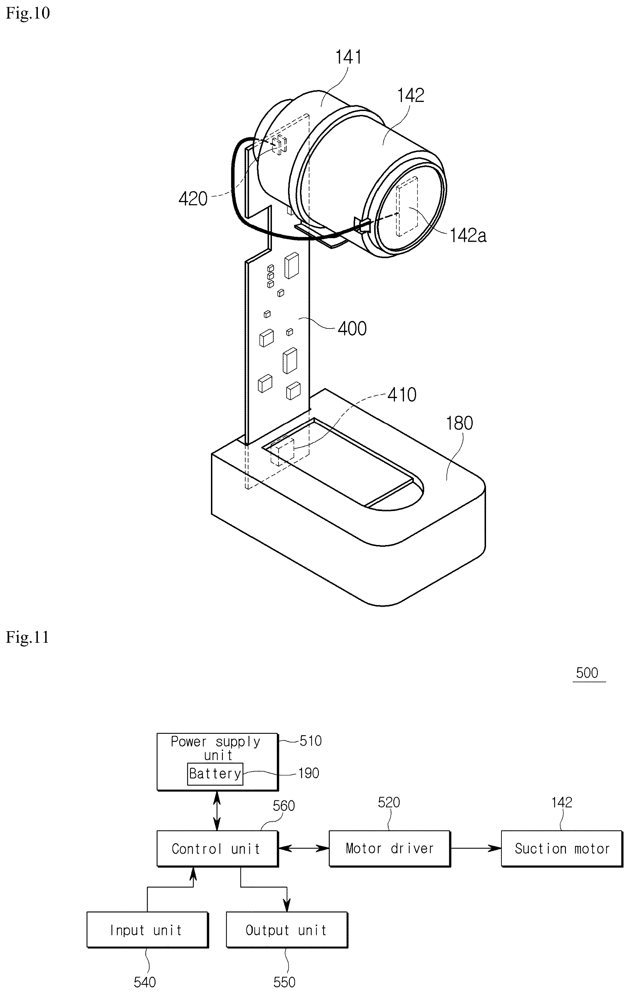

Meanwhile, FIG. 9 is a view for describing an arrangement structure of the suction motor, the printed circuit board, and the battery according to another embodiment of the present disclosure, and FIG. 10 is a view for describing an arrangement structure of the suction motor, the printed circuit board, and the battery according to still another embodiment of the present disclosure.

Referring to FIG. 9, an arrangement structure of the suction motor 142, the printed circuit board 400, and the battery 190 according to another embodiment of the present disclosure will be described as below.

The printed circuit board 400 may include the battery connecting element 410 mounted on one surface thereof and the motor connecting element 420 mounted on another surface thereof. In addition, it may be disposed such that an axial direction of the suction motor 142 and an arrangement direction of the printed circuit board 400 intersect each other, and the suction motor control board 142a of the suction motor 142 are in contact with the motor connecting element 420 to be electrically connected thereto. That is, the suction motor 142 may be electrically connected to the printed circuit board 400 as the suction motor control board 142a and the motor connecting element 420 are in contact with each other physically, and may be fixed to a position adjacent to an end of the printed circuit board 400.

That is, the motor axis of the suction motor 142 may be disposed along the forward and rearward directions.

In addition, the printed circuit board 400 may be disposed to be elongated along a direction intersecting the long side of the battery 190.

In addition, based on the longitudinal axis A1 of the suction part 120, the battery 190 and the suction motor 142 may be disposed to be parallel to the longitudinal axis A1 of the suction part 120 at positions adjacent to one end and another end of the printed circuit board 400, respectively.

Referring to FIG. 10, an arrangement structure of the suction motor 142, the printed circuit board 400, and the battery 190 according to still another embodiment of the present disclosure will be described as below.

The suction motor 142 and the battery 190 may be disposed to be opposed to one surface of the printed circuit board 400. Accordingly, the printed circuit board 400 may include the battery connecting element 410 mounted on one surface thereof and the motor connecting element 420 mounted on another surface thereof, and the line 142b connected to the suction motor 142 may pass through the printed circuit board 400 and may be connected to the motor connecting element 420 mounted on another surface of the printed circuit board 400.

Alternatively, the printed circuit board 400 may include the battery connecting element 410 and the motor connecting element 420 mounted on one surface thereof, and the line 142b connected to the suction motor 142 may be connected to the motor connecting element 420 mounted on one surface of the printed circuit board 400, and the line 142b may be minimized.

In addition, it may be possible that the axial direction of the suction motor 142 and the arrangement direction of the printed circuit board 400 may intersect each other, and the impeller 141 may be disposed on one side of the suction motor 142 in an axial direction, and may be positioned between the suction motor 142 and the printed circuit board 400, or disposed on another side of the suction motor 142 in the axial direction. In addition, the printed circuit board 400 may be disposed to be elongated along a direction intersecting the long side of the battery 190.

In addition, based on the longitudinal axis A1 of the suction part 120, the battery 190 and the suction motor 142 may be disposed to be parallel to the longitudinal axis A1 of the suction part 120 at positions adjacent to one end and another end of the printed circuit board 400, respectively.

In FIG. 11, an internal block diagram of a motor driving unit according to an embodiment of the present disclosure is illustrated.

Referring to FIG. 11, the motor driving unit 500 may include, for example, a power supply unit 510, a motor driver 520, the suction motor 142, an input unit 540, an output unit 550, and/or a control unit 560.

The power supply unit 510 may supply power to the motor driving unit 500.

The power supply unit 510 may convert alternating current power, which is input from a commercial AC power supply, into direct current power and may supply it as the power of the motor driving unit 500. For example, the power supply unit 510 may include a converter (not illustrated), and may convert the AC power into the DC power through the converter.

The power supply unit 510 may include the battery 190 configured to store the DC power. For example, the power supply unit 510 may supply the DC power stored in the battery 190 as the power of the motor driving unit 500.

The power supply unit 510 may convert the commercial AC power into the DC power and may store it in the battery 190.

The power supply unit 510 may further include a DC-stage capacitor (not illustrated), and may store the DC power converted through the converter and/or the DC power supplied from the battery 190 in the DC-stage capacitor.

The motor driver 520 may drive, for example, the suction motor 142. For example, the motor driver 520 may drive the suction motor 142 based on the power supplied from the power supply unit 510.

The motor driver 520 may include a plurality of switching elements, and an inverter (not illustrated) configured to convert the DC power to the AC power at a predetermined frequency and output the AC power through turning on/off of the switching element, and may supply the AC power output from the inverter to the suction motor 142. Here, the inverter may be the suction motor control board 142a.

The motor driver 520 may further include, for example, a current detection unit (not illustrated) configured to detect a current flowing in each component of the motor driving unit 500, and/or a voltage detection unit (not illustrated) configured to detect a voltage applied to each component thereof.

The current detection unit may include a current sensor, a current transformer (CT), a shunt resistance, and the like, for example, for detection of the current, and the detected current may be input to the control unit 260.

The voltage detection unit may include a resistor element, an operational amplifier (an op-amp), and the like, for example, for detection of the voltage, and the detected voltage may be input to the control unit 260.

The suction motor 142 may operate according to the power supplied from the motor driver 520.

The suction motor 142 may operate according to the AC power at a predetermined frequency supplied from the motor driver 520. For example, the operation of the suction motor 142 may be changed according to a magnitude of the power and/or a frequency supplied from the motor driver 520.

The input unit 540 may include an input device (e.g., a key, a touch panel, and the like) through which the input of the user is received. For example, the input unit 540 may include the operating part 164 which includes a power key for turning on/off the power of the motor driving unit 500, an operation key for setting the operation of the motor driving unit 500, and the like.

The input unit 540 may receive the input of the user through an input device, and may transmit an instruction corresponding to the input of the user to the control unit 560. For example, the control unit 560 may determine an operation mode of the motor driving unit 500 based on the input of the user input through the input unit 540.

The output unit 550 may include a display device such as a display (not illustrated), a light emitting diode (LED), and the like, for example. For example, the output unit 550 may display an on/off state of the power of the motor driving unit 500, a driving state according to the operation mode, a message related to occurrence of an error, and the like.

The output unit 550 may include an audio device such as a speaker, a buzzer, and the like. For example, the output unit 550 may output a sound effect according to the on/off state of the power of the motor driving unit 500, a sound effect according to a change of the operation mode, an alarm sound with respect to the error occurrence, and the like.

The control unit 560 may be connected to each component provided in the motor driving unit 500. The control unit 560 may receive or send a signal with each component of the motor driving unit 500 and may control the overall operations of each component.

The control unit 560 may include a converter control unit (not illustrated) configured to control an operation of the converter, and/or an inverter control unit (not illustrated) configured to control an operation of the inverter. According to an embodiment of the present disclosure, the converter control unit and the inverter control unit may be included in the same component, or may be included in components separated from each other.

The control unit 560 may control an operation of the motor driver 520. For example, the control unit 560 may output a switching control signal for controlling a switching operation of the inverter included in the motor driver 520.

The control unit 560 may calculate a current flowing in the suction motor 142. For example, the control unit 560 may calculate a current flowing in the suction motor 142 through the current detection unit.

The control unit 560 may calculate a rotational speed of the suction motor 142. For example, the control unit 560 may calculate a rotational speed of the suction motor 142 based on a phase current flowing in the suction motor 142.

The control unit 560 may calculate a position of the rotor of the suction motor 142. For example, the control unit 560 may calculate the position of the rotor of the suction motor 142 based on the phase current flowing in the suction motor 142.

While the present disclosure has been described with reference to the specific embodiments, the specific embodiments are only for specifically explaining the present disclosure, and the present disclosure is not limited to the specific embodiments. It is apparent that the present disclosure may be modified or altered by those skilled in the art without departing from the technical concept of the present disclosure.

All the simple modifications or alterations to the present disclosure fall within the scope of the present disclosure, and the specific protection scope of the present disclosure will be defined by the appended claims.

## Claims

1. A cleaner (1), comprising:
a suction part (120) in which a suction flow path through which air flows is formed;
a dust separating part (130) comprising at least one cyclone unit;
a suction motor (142) configured to provide a flow force of air;
a main body housing (110) having the suction part (120) provided on one side thereof and the dust separating part (130) and the suction motor (142) provided therein;
a battery (190) configured to supply power to the suction motor (142); and
a printed circuit board (400) having at least one surface opposed to each of the suction motor (142) and the battery (190), and a plurality of elements mounted therein.

2. The cleaner (1) of claim 1, further comprising:
a handle housing (160) coupled to the main body housing (110) to provide a handle (163) and to which the battery (190) is detachably coupled,
wherein the printed circuit board (400) is disposed in upward and downward directions of the main body housing (110) and an upper end thereof is disposed to be opposed to the suction motor (142) and a lower end thereof is disposed to be opposed to the battery (190).

3. The cleaner (1) of claim 2, wherein the handle housing (160) comprises:
a main body coupling portion (161) coupled to the main body housing (110); and
a seating portion (162) configured to allow the printed circuit board (400) to be accommodated in the main body coupling portion (161) to be fixed thereto.

4. The cleaner (1) of claim 1, wherein the main body housing (110) comprises at least one board supporting portion (112) protruding toward the printed circuit board (400) on an outer circumferential surface of the main body housing (110) so that the printed circuit board (400) is seated thereon to be fixed thereto.

5. The cleaner (1) of claim 1, wherein in the main body housing (110), the suction motor (142) is disposed on an inside thereof and the printed circuit board (400) is disposed on an outside thereof.

6. The cleaner (1) of claim 1, wherein in the printed circuit board (400), a battery connecting element (410) configured to allow the battery (190) to be attached or detached thereto/therefrom and electrically connected thereto is mounted and a motor connecting element (420) to which the suction motor (142) is electrically connected is mounted.

7. The cleaner (1) of claim 6, wherein the printed circuit board (400) allows the battery connecting element (410) to be mounted on one surface thereof, and the motor connecting element (420) to be mounted on another surface thereof.

8. The cleaner (1) of claim 6, wherein the printed circuit board (400) allows the battery connecting element (410) and the motor connecting element (420) to be mounted on one surface thereof.

9. The cleaner (1) of claim 6, wherein in the printed circuit board (400), the suction motor (142) is in direct contact with the motor connecting element (420) to be connected to each other.

10. The cleaner (1) of claim 6, wherein in the printed circuit board (400), the suction motor (142) is connected to the motor connecting element (420) through wiring (142b).

11. The cleaner (1) of claim 1, wherein the printed circuit board (400) is disposed along a direction intersecting a direction in which the suction part (120) is disposed.

12. A cleaner (1), comprising:
a main body housing (110) having a suction part (120) in which a suction flow path through which air flows is formed, a dust separating unit (130) configured to separate dust from air, and a suction motor (142) configured to provide a suction force to the suction part (120);
a handle housing (160) coupled to the main body housing (110) and to which a battery (190) configured to supply power to the suction motor (142) is detachably coupled; and
a printed circuit board (400) electrically connected to the suction motor (142) and the battery (190),
**characterized in that** wherein the printed circuit board (400) is disposed between the main body housing (110) and the handle housing (160) and is fixed to the main body housing (110), or the handle housing (160).

13. A cleaner (1), comprising:
a suction part (120) in which a suction flow path through which air flows is formed;
a dust separating unit (130) configured to separate dust from the air sucked through the suction part (120);
a suction motor (142) configured to generate a suction force for sucking in air through the suction part (120);
a battery (190) configured to supply power to the suction motor (142); and
a printed circuit board (400) disposed in a direction intersecting a direction in which the suction part (120) is disposed and having one end to which the battery (190) is electrically connected and another end to which the suction motor (142) is electrically connected.
